# EUROPÄISCHE PATENTSCHRIFT

(11) **EP 3 229 564 B1**
(45) Veröffentlichungstag und Bekanntmachung des Hinweises auf die Patenterteilung: **28.02.2018**
(21) Anmeldenummer: 16163665.9
(22) Anmeldetag: 04.04.2016
(51) Int. Cl.: H05K 1/11, H05K 1/14, H05K 3/34, H05K 3/36

(54) **LEITERPLATTENANORDNUNG UND SENSOR**
PRINTED CIRCUIT BOARD ASSEMBLY AND SENSOR
SYSTEME DE CARTES DE CIRCUIT IMPRIME ET CAPTEUR

(43) Veröffentlichungstag der Anmeldung: 11.10.2017
(73) Patentinhaber: SICK AG, 79183 Waldkirch (DE)
(72) Erfinder: Birkle, Stefan, 79276 Reute (DE); Reichenbach, Hans-Peter, 79286 Glottertal (DE)

(56) Entgegenhaltungen:
- US-A1- 2011 063 816
- US-B1- 7 084 353

## Beschreibung

Die vorliegende Erfindung betrifft eine Leiterplattenanordnung mit mindestens zwei senkrecht zueinander stehenden Leiterplatten nach dem Oberbegriff von Anspruch 1.

Eine Miniaturisierung von Sensoren erhöht die Anforderungen an eine Verbindungstechnik, die zur Kontaktierung von Signalen zweier Leiterplatten oder Elektronikkarten benötigt wird.

In einem begrenzten Bauraum kommt es zum Ressourcenkonflikt zwischen einer Leiterplattenfläche, Anzahl der Verbindungen zwischen den Leiterplatten und den Kosten für eine Prozessstabilität. Eine kostengünstige Lösung zum elektrischen Verbinden der Leiterplatten für Signale ist das Verlöten der Kontaktstellen zweier Elektronikkarten. Zur Verbesserung der Prozessqualität werden selektive Lötverfahren eingesetzt. Bei einer steigenden Anzahl von benötigten Signalwegen ist es notwendig, immer mehr Lötstellen auf immer kleiner werdenden Flächen unterzubringen.

Durch die konstruktiven Vorgaben müssen durch die Lötpads oder Lötkontaktflächen zwei Leiterplatten durch Lötstellen mit sehr geringen Lötkontaktflächenabständen verbunden werden. Durch die geringen Abstände neigen die Lötungen zu Brückenbildungen bzw. zu keiner Verbindung. Ebenfalls wird durch das kleine Rastermaß die Anforderung an die Positionierung der Leiterplatten zueinander deutlich höher.

Lötpads bzw. Kontaktflächen für eine Lötverbindung nach dem Stand der Technik zeigen quadratische bzw. rechteckige identische Grundformen, z. B. bei Kehlnahtlötungen.

Die DE 100 48 290 A1 offenbart einen Sensor mit zwei Leiterplatten, die über Lötpads miteinander verbunden sind.
Die US 2011/0063816 A1 offenbart zwei Leiterplatten, die senkrecht zueinander verlötet sind, gemäß dem Oberbegriff des Anspruchs 1. Die US 7 084 353 B1 offenbart eine Leiterplatte mit sechseckigen Lötpads.
Eine Aufgabe der Erfindung besteht darin, eine verbesserte Leiterplattenanordnung bereitzustellen. Insbesondere besteht die Aufgabe darin, verbesserte Kontaktflächen für eine senkrechte Leiterplattenverbindung bereitzustellen. Weiter besteht die Aufgabe darin, die Kontaktflächen zu verkleinern, so dass eine größere Anzahl von Kontaktflächen nebeneinander angeordnet werden können.
Die Aufgabe wird gemäß Anspruch 1 gelöst durch eine Leiterplattenanordnung mit mindestens zwei senkrecht zueinander stehenden Leiterplatten, wobei eine erste Leiterplatte an einer Seite an einer Leiterplattenkante erste Kontaktflächen aufweist, wobei eine zweite Leiterplatte auf einer Seite zweite Kontaktflächen aufweist, wobei die zweiten Kontaktflächen der zweiten Leiterplatte senkrecht liegend an den ersten Kontaktflächen der ersten Leiterplatte angeordnet sind und die ersten Kontaktflächen der ersten Leiterplatte mit den zweiten Kontaktflächen der zweiten Leiterplatte elektrisch mittels Lötmittel verbunden sind, wobei die Kontaktflächen einer Leiterplatte entlang einer Verbindungsstelle zur anderen Leiterplatte überstehend zu gegenüberliegenden Kontaktflächen der gegenüberliegenden Leiterplatte sind und sich mindestens die Kontaktflächen der gegenüberliegenden Leiterplatte in Richtung der Verbindungsstelle verjüngen oder verkleinern, wobei die Kontaktflächen einer Leiterplatte mindestens einen kreisförmigen Flächenabschnitt und einen damit verbundenen rechteckförmigen Flächenabschnitt aufweist, wobei der rechteckförmige Flächenabschnitt zwischen dem kreisförmigen Flächenabschnitt und der Verbindungsstelle liegt und der rechteckförmige Flächenabschnitt eine kleinere Breite aufweist als ein Durchmesser des kreisförmigen Flächenabschnittes.
Gemäß der vorliegenden Erfindung wird eine Prozesssicherheit beim Verbinden der zwei Leiterplatten verbessert, da eine unerwünschte Verbindung zwischen zwei benachbarten Lötstellen verhindert wird.
Durch die spezielle Gestaltung der Geometrie der Kontaktfläche, nämlich der Verjüngung oder Verkleinerung in Richtung der Verbindungsstelle wird verhindert, dass sich das Lötmittel zur benachbarten Lötstelle hin ausbreitet. Durch die spezielle Geometrie der mindestens einen Kontaktfläche, wonach diese sich in Richtung der Verbindungsstelle verjüngt oder verkleinert, bildet das Lötmittel einen Meniskus, also eher eine nach innen gewölbte, konkave Oberfläche des Lötmittels aus und keine Lötmittelkugel wie beim Stand der Technik.

Gemäß der Erfindung kann daher der Abstand zwischen benachbarten Kontaktflächen einer Leiterplatte verringert werden, so dass mehr Kontaktflächen nebeneinander auf der Leiterplatte angeordnet werden können.

Weiter kann ein Verschiebungsversatz bzw. lateraler Versatz in Richtung der flächigen Ausdehnung der zu verbindenden Kontaktflächen ausgeglichen werden. Dabei kann der Versatz größer gewählt werden als bei herkömmlichen Lötverbindungen.

Weiter kann durch eine Länge der zweiten Kontaktflächen eine Verschiebung der ersten Leiterplatte in Richtung der Länge der zweiten Kontaktflächen ausgeglichen werden. Dadurch können auch größere Toleranzen in Richtung der Länge der zweiten Kontaktflächen zugelassen werden.

Weiter kann ein Lötspalt zwischen den Leiterplatten überbrückt werden. Der Lötspalt wird durch zusätzliches Lötmittel überbrückt. Durch die Form der mindestens einen Kontaktfläche entsteht in dem überbrückten Bereich keine Lötmittelkugel, sondern durch die Form, nämlich die Verjüngung bzw. Verkleinerung der Kontaktflächengröße zur Verbindungsstelle hin, eine konkave, also nach innen gewölbte Oberfläche des Lötmittels.

Weiter kann die Lötmittelmenge reduziert werden. Die Lotmittelmenge wird gemäß der Erfindung auch besser verteilt. Bei dem Lötmittel handelt es sich um Lötzinn oder ein ähnliches Lötmittel.

Gemäß der Erfindung weisen die Kontaktflächen einer Leiterplatte mindestens einen kreisförmigen Flächenabschnitt und einen damit verbundenen rechteckförmigen Flächenabschnitt auf, wobei der rechteckförmige Flächenabschnitt zwischen dem kreisförmigen Flächenabschnitt und der Verbindungsstelle liegt und der rechteckförmige Flächenabschnitt eine kleinere Breite aufweist als ein Durchmesser des kreisförmigen Flächenabschnittes. Dadurch wird ebenso eine Verjüngung oder Verkleinerung der Kontaktflächen in Richtung der Verbindungsstelle erreicht.

Der kreisförmige Flächenabschnitt dient bevorzugt als Reservoir für das Lötmittel, um die Lötstelle während der Lötung mit Lötmittel zu versorgen. Dadurch können auch größere Spaltmaße zwischen den Leiterplatten überbrückt werden. Beispielsweise kann ein Spaltmaß von bis zu 0,2 mm zwischen den Leiterplatten überbrückt werden.

In Weiterbildung der Erfindung sind die Kontaktflächen der ersten Leiterplatte oder die Kontaktflächen der zweiten Leiterplatte tropfenförmig ausgebildet. Die tropfenförmige Form der Kontaktflächen führt zu einer gleichmäßigen Oberfläche der Lötmittelverbindung.

In Weiterbildung der Erfindung liegt ein Kontaktmittenabstand im Bereich von 0,5 mm bis 2 mm, insbesondere 0,5 mm bis 1,5 mm, insbesondere bei 1,25 mm. Durch eine Verkleinerung des Kontaktmittenabstandes kann eine höhere Zahl von Kontakten entlang der Leiterplatte angeordnet werden. Bei einer Verringerung der Kontaktmittenabstände wird auch die Kontaktbreite der Kontaktflächen verringert.

In Weiterbildung der Erfindung weist ein Sensor, insbesondere eine Lichtschranke oder ein Lichttaster, eine Leiterplattenanordnung auf.

Die Leiterplattenanordnung wird bevorzugt in einem Sensor, einer Lichtschranke oder einem Lichttaster angeordnet. Eine Lichtschranke kann dabei als Einweglichtschranke ausgebildet sein. Dabei sind Lichtsender und Lichtempfänger gegenüberliegend angeordnet und eine Unterbrechung des Lichtstrahls führt in der Auswerteeinheit des Lichtempfängers zu einem Objektfeststellungssignal. Bei einer Reflexionslichtschranke sind Lichtsender und Lichtempfänger auf der gleichen Seite eines Überwachungsbereiches, meist in einem einzigen Gehäuse untergebracht. Gegenüberliegend ist ein Retroreflektor angeordnet, der das vom Lichtsender ausgesandte Licht um 180° zurückreflektiert in den Lichtempfänger.

Bei einem Lichttaster sind Lichtsender und Lichtempfänger in einem gemeinsamen Gehäuse angeordnet. Die vom Lichtsender ausgesandten Lichtstrahlen werden an einem Objekt reflektiert oder remittiert. Dabei kann das empfangene Licht energetisch ausgewertet werden. Falls ein bestimmter Schwellwert überschritten wird, wird ein Objektfeststellungssignal ausgegeben.

Jedoch kann der Lichttaster auch als Triangulationstaster ausgebildet sein. Bei einem Triangulationstaster ist das Empfangselement ortsauflösend ausgebildet und der Lichtsender beabstandet zum Empfangselement angeordnet. Ein vom Lichtsender ausgesendeter Lichtspot wird von einem Objekt zurück, über die Empfangslinse auf das ortsauflösende Empfangselement abgebildet. Je nach Entfernung des Objektes wird der Lichtspot an unterschiedlichen Positionen abgebildet, wobei von der Position des Lichtspots auf dem Empfangselement auf die Entfernung des Objektes geschlossen werden kann.

Ein Sensor kann auch ein Sensor nach dem Lichtlaufzeitverfahren sein. Dabei wird vom Lichtsender ein kurzer Lichtimpuls bzw. eine Gruppe von Lichtimpulsen ausgesendet. Der oder die Lichtimpulse werden von einem Objekt reflektiert bzw. remittiert und vom Empfangselement des Lichtempfängers empfangen. Von einer nachgeordneten Auswerteeinheit wird die Laufzeit des Lichtes vom Aussenden bis zum Empfangen ausgewertet und daraus die Entfernung des Objektes berechnet.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:
- Figur 1 und 2: jeweils eine Leiterplattenanordnung;
- Figur 3 bis Figur 5: die Leiterplattenanordnung gemäß Figur 2 in drei verschiedenen Ansichten in verlötetem Zustand;
- Figur 6 und 7: jeweils eine weitere Leiterplattenanordnung;
- Figur 8 bis 10: jeweils einen Sensor mit einer Leiterplattenanordnung.

In den nachfolgenden Figuren sind identische Teile mit identischen Bezugszeichen versehen.

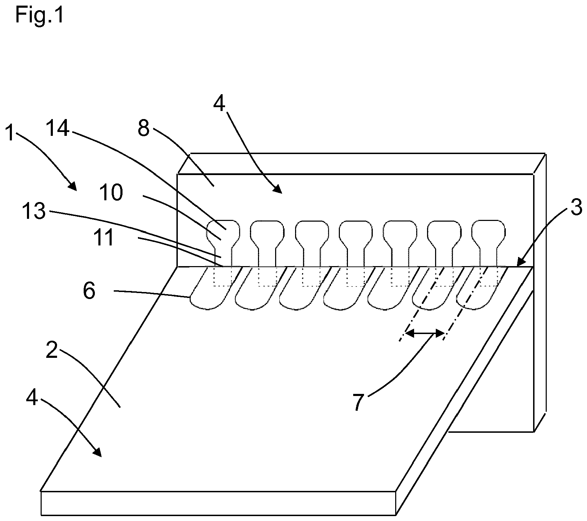

Figur 1 zeigt schematisch eine Leiterplattenanordnung 1 mit mindestens zwei senkrecht zueinander stehenden Leiterplatten 2 und 8, wobei eine erste Leiterplatte 2 an einer Seite 4 an einer Leiterplattenkante 3 erste Kontaktflächen 6 aufweist, wobei eine zweite Leiterplatte 8 auf einer Seite 4 zweite Kontaktflächen 10 aufweist, wobei die zweiten Kontaktflächen 10 der zweiten Leiterplatte 8 senkrecht liegend an den ersten Kontaktflächen 6 der ersten Leiterplatte 2 angeordnet sind und die ersten Kontaktflächen 6 der ersten Leiterplatte 2 mit den zweiten Kontaktflächen 10 der zweiten Leiterplatte 8 elektrisch mittels Lötmittel verbindbar sind, wobei die Kontaktflächen 6 einer Leiterplatte 2 entlang einer Verbindungsstelle 11 zur anderen Leiterplatte 8 überstehend zu gegenüberliegenden Kontaktflächen 10 der gegenüberliegenden Leiterplatte 8 sind und mindestens die Kontaktflächen 10 der gegenüberliegenden Leiterplatte 8 sich in Richtung der Verbindungsstelle 11 verjüngen oder verkleinern.

Die Kontaktflächen 10 sind dabei optional länger ausgebildet, so dass diese auf der Oberfläche der zweiten Leiterplatte 8 über die Verbindungsstelle 11 hinausragen. Dadurch kann eine Verschiebung der ersten Leiterplatte 2 entlang der zweiten Leiterplatte 8 in Richtung der Länge der zweiten Kontaktflächen 10 ausgeglichen werden, da an der Verbindungsstelle 11 die Kontaktflächen auch bei einer Verschiebung aufeinandertreffen.

Die Kontaktfläche 10 weist beispielsweise einen rechteckförmigen Flächenabschnitt 14 mit abgerundeten Ecken auf, der breiter ist als der rechteckförmige Flächenabschnitt 13.

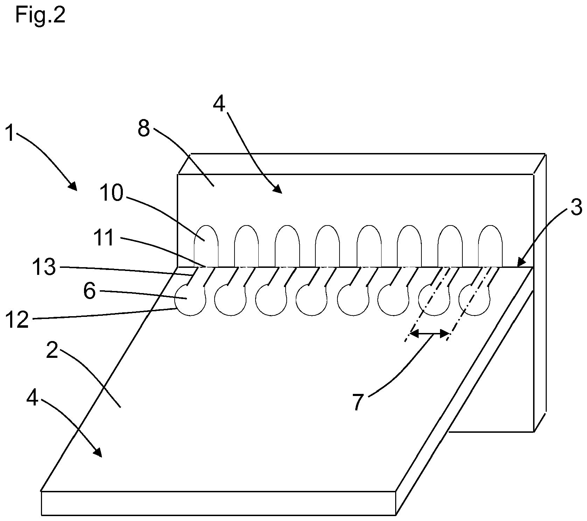

Figur 2 zeigt schematisch ein weiteres Ausführungsbeispiel einer Leiterplattenanordnung 1 mit mindestens zwei senkrecht zueinander stehenden Leiterplatten 2 und 8, wobei eine erste Leiterplatte 2 an einer Seite 4 an einer Leiterplattenkante 3 erste Kontaktflächen 6 aufweist, wobei eine zweite Leiterplatte 8 auf einer Seite 4 zweite Kontaktflächen 10 aufweist, wobei die zweiten Kontaktflächen 10 der zweiten Leiterplatte 8 senkrecht liegend an den ersten Kontaktflächen 6 der ersten Leiterplatte 2 angeordnet sind und die ersten Kontaktflächen 6 der ersten Leiterplatte 2 mit den zweiten Kontaktflächen 10 der zweiten Leiterplatte 8 elektrisch mittels Lötmittel verbindbar sind, wobei die Kontaktflächen 10 einer Leiterplatte 8 entlang einer Verbindungsstelle 11 zur anderen Leiterplatte 2 überstehend zu gegenüberliegenden Kontaktflächen 6 der gegenüberliegenden Leiterplatte 2 sind und mindestens die Kontaktflächen 6 der gegenüberliegenden Leiterplatte 2 sich in Richtung der Verbindungsstelle 11 verjüngen oder verkleinern.

Die Kontaktflächen 10 sind dabei gemäß Figur 2 ebenfalls optional länger ausgebildet, so dass diese auf der Oberfläche der zweiten Leiterplatte 8 über die Verbindungsstelle 11 hinausragen. Dadurch kann eine Verschiebung der ersten Leiterplatte 2 entlang der zweiten Leiterplatte 8 in Richtung der Länge der zweiten Kontaktflächen 10 ausgeglichen werden, da an der Verbindungsstelle 11 die Kontaktflächen auch bei einer Verschiebung aufeinandertreffen.

Gemäß Figur 1 oder Figur 2 liegt ein Kontaktmittenabstand 7 im Bereich von 0,5 mm bis 2 mm, insbesondere 0,5 mm bis 1,5 mm, insbesondere bei 1,25 mm.

Gemäß Figur 2 weisen die ersten Kontaktflächen 6 der ersten Leiterplatte 2 mindestens einen kreisförmigen Flächenabschnitt 12 und einen damit verbundenen rechteckförmigen Flächenabschnitt 13 auf, wobei der rechteckförmige Flächenabschnitt 13 zwischen dem kreisförmigen Flächenabschnitt 12 und der Verbindungsstelle 11 liegt und der rechteckförmige Flächenabschnitt 13 eine kleinere Breite aufweist als ein Durchmesser des kreisförmigen Flächenabschnittes 12. Dadurch wird eine Verjüngung oder eine Verkleinerung der ersten Kontaktfläche 6 in Richtung der Verbindungsstelle 11 erreicht. Der rechteckförmige Flächenabschnitt 13 weist dabei eine geringere Breite auf als der Durchmesser des kreisförmigen Flächenabschnittes 12.

Der kreisförmige Flächenabschnitt 12 dient bevorzugt als Reservoir für das Lötmittel, um die Lötstelle während der Lötung mit Lötmittel zu versorgen.

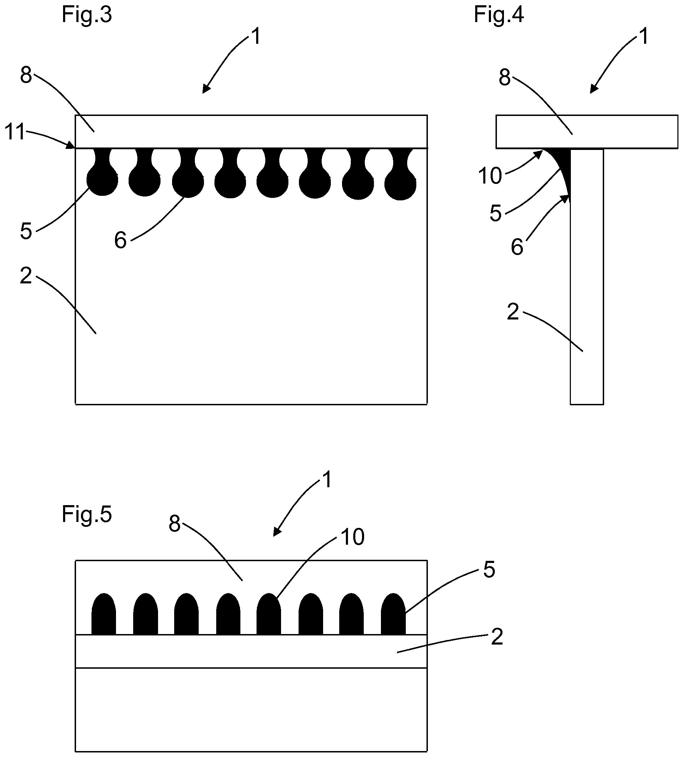

Figur 3 zeigt schematisch die erste Leiterplatte 2 aus Figur 2 in einer Draufsicht, wobei die Kontaktflächen mit Lötmittel 5 benetzt sind und mit der zweiten Leiterplatte 8 verlötet sind. Dadurch, dass die ersten Kontaktflächen 6 sich in Richtung der Verbindungsstelle 11 verjüngen oder verkleinern, bildet sich eine konkave oder nach innen gewölbte Lötfläche oder Lötstelle, wodurch eine Kontaktierung zwischen benachbarten Kontaktflächen entlang der Leiterplatte vermieden wird.

Durch die spezielle Geometrie der mindestens einen Kontaktfläche 6, wonach diese sich in Richtung der Verbindungsstelle 11 verjüngt oder verkleinert, bildet das Lötmittel 5 einen Meniskus, also eher eine nach innen gewölbte, konkave Oberfläche des Lötmittels 5 aus.

Gemäß der Erfindung kann daher der Abstand zwischen benachbarten Kontaktflächen 6 einer Leiterplatte 2 verringert werden, so dass mehr Kontaktflächen 6 nebeneinander auf der Leiterplatte 2 angeordnet werden können.

Figur 4 zeigt die Leiterplattenanordnung 1 aus Figur 3 in einer Seitenansicht mit der ersten Kontaktfläche 6 und der zweiten Kontaktfläche 10. Das Lötmittel 5 der Lötstelle weist auch in dieser dargestellten Ebene eine konkave oder nach innen gewölbte Oberfläche auf.

Figur 5 zeigt die Leiterplattenanordnung 1 aus Figur 3 in einer Draufsicht auf die zweite Leiterplatte 8 mit den zweiten Kontaktflächen 10.

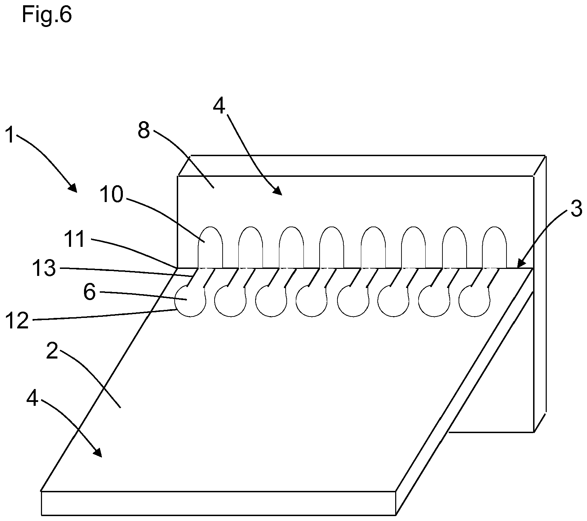

Figur 6 zeigt die Leiterplattenanordnung aus Figur 2, wobei die erste Leiterplatte 2 gegenüber der zweiten Leiterplatte 8 entlang der Verbindungsstelle 11 verschoben ist. Gemäß Figur 6 kann ein Verschiebungsversatz bzw. lateraler Versatz in Richtung der flächigen Ausdehnung der zu verbindenden Kontaktflächen 6 und 10 ausgeglichen werden. Dabei kann der Versatz größer gewählt werden als bei herkömmlichen Lötverbindungen. Die zweite Kontaktfläche 10 ist nur noch an einer Seite zur ersten Kontaktfläche 6 überstehend angeordnet. An der gegenüberliegenden Seite der zweiten Kontaktfläche 10 ist diese bündig zur ersten Kontaktfläche 6 angeordnet. Diese Anordnung kann ebenso zuverlässig verlötet werden wie die Anordnung gemäß Figur 1, da durch die überstehende Ausbildung der zweiten Kontaktflächen 10 ein Versatz entlang der Verbindungsstelle ausgeglichen wird. Durch die Verjüngung oder Verkleinerung der ersten Kontaktflächen 6 in Richtung zur Verbindungsstelle 11 wird weiter eine Lötstelle erzeugt die konkave, also nach innen gewölbte Oberflächen aufweist.

Gemäß Figur 6 kann die erste Leiterplatte 2 auch entlang der zweiten Leiterplatte 8 in Richtung der Längsausdehnung der zweiten Kontaktflächen 10 verschoben sein. Durch die längliche Ausbildung der zweiten Kontaktflächen 10 bzw. durch eine Länge der zweiten Kontaktflächen 10 kann eine Verschiebung der ersten Leiterplatte 2 in Richtung der Länge der zweiten Kontaktflächen 10 ausgeglichen werden. Dadurch können auch größere Toleranzen in Richtung der Länge der zweiten Kontaktflächen 10 zugelassen werden.

Weiter kann ein Spalt bzw. ein Lötspalt zwischen den Leiterplatten überbrückt werden. Der Lötspalt wird durch zusätzliches Lötmittel überbrückt. Dadurch können die Leiterplatten 2 und 8 prozesssicher verlötet werden, trotz höherer Toleranzen bei der Verbindung der Leiterplatten 2 und 8 in mindestens drei Raumrichtungen.

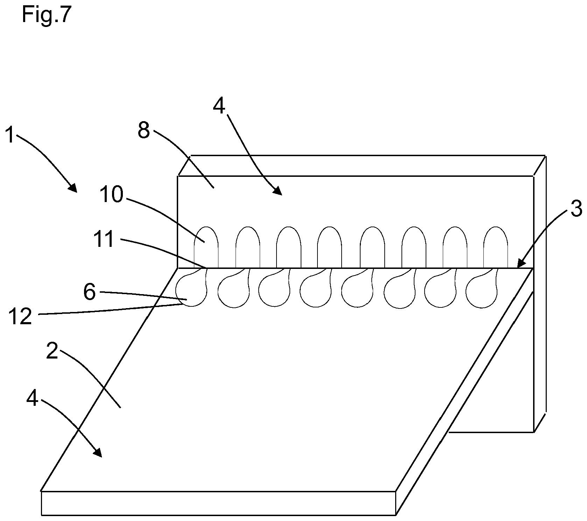

Gemäß Figur 7 sind die ersten Kontaktflächen 6 der ersten Leiterplatte 2 beispielsweise tropfenförmig ausgebildet. Die tropfenförmige Form der Kontaktflächen 6 führt ebenso zu einer gleichmäßigen nach innen gewölbten Oberfläche der Lötmittelverbindung. Jedoch können auch andere Formen der ersten Kontaktfläche 6 vorgesehen sein, solange sich die Kontaktfläche 6 zur Verbindungsstelle 11 hin verkleinert oder verjüngt. Beispielsweise kann die Kontaktfläche 6 auch keilförmig ausgebildet sein. Die Kontur der Kontaktfläche 6 kann dabei gerade oder auch nach innen gewölbt sein, wie in Figur 7 dargestellt.

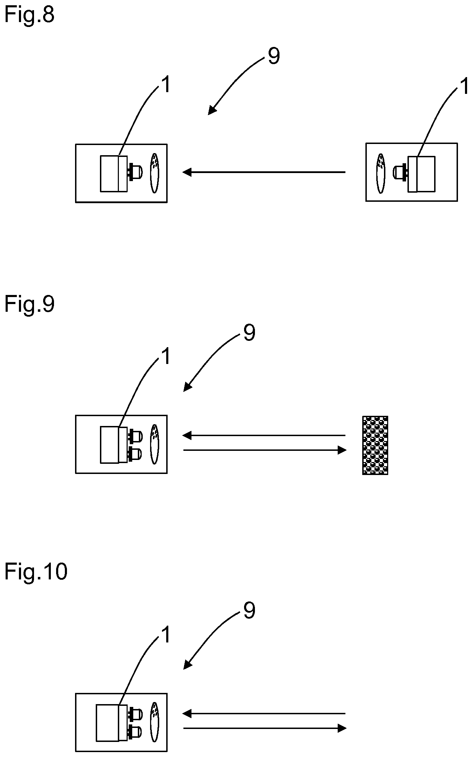

Gemäß Figur 8 weist ein Sensor 9, insbesondere eine Lichtschranke, die Leiterplattenanordnung 1 auf.

Der Sensor 9 kann gemäß Figur 9 auch als Reflexionslichtschranke oder gemäß Figur 10 als Lichttaster ausgebildet sein und die Leiterplattenanordnung 1 aufweisen.

### Bezugszeichen:

1 Leiterplattenanordnung
2 erste Leiterplatte
3 Leiterplattenkante
4 Seite
5 Lötmittel
6 erste Kontaktflächen
7 Kontaktmittenabstand
8 zweite Leiterplatte
9 Sensor
10 zweite Kontaktflächen
11 Verbindungsstelle
12 kreisförmiger Flächenabschnitt
13 rechteckförmiger Flächenabschnitt
14 rechteckförmiger Flächenabschnitt

## Patentansprüche

1. Leiterplattenanordnung mit mindestens zwei senkrecht zueinander stehenden Leiterplatten (2, 8), wobei eine erste Leiterplatte (2) an einer Seite (4) an einer Leiterplattenkante (3) erste Kontaktflächen (6) aufweist,
wobei eine zweite Leiterplatte (8) auf einer Seite (4) zweite Kontaktflächen (10) aufweist, wobei die zweiten Kontaktflächen (10) der zweiten Leiterplatte (8) senkrecht liegend an den ersten Kontaktflächen (6) der ersten Leiterplatte (2) angeordnet sind und die ersten Kontaktflächen (6) der ersten Leiterplatte (2) mit den zweiten Kontaktflächen (10) der zweiten Leiterplatte (8) elektrisch mittels Lötmittel (5) verbunden sind,
wobei
die Kontaktflächen (6, 10) einer Leiterplatte (2, 8) entlang einer Verbindungsstelle (11) zur anderen Leiterplatte (8, 2) überstehend zu gegenüberliegenden Kontaktflächen (10, 6) der gegenüberliegenden Leiterplatte (8, 2) sind und mindestens die Kontaktflächen (6, 10) der gegenüberliegenden Leiterplatte (2, 8) sich in Richtung der Verbindungsstelle (11) verjüngen oder verkleinern, **dadurch gekennzeichnet, dass** die Kontaktflächen (6, 10) einer Leiterplatte (2, 8) mindestens einen kreisförmigen Flächenabschnitt (12) und einen verbundenen rechteckförmigen Flächenabschnitt (13) aufweisen, wobei der rechteckförmige Flächenabschnitt (13) zwischen dem kreisförmigen Flächenabschnitt (12) und der Verbindungsstelle (11) liegt und der rechteckförmige Flächenabschnitt (13) eine kleinere Breite aufweist als ein Durchmesser des kreisförmigen Flächenabschnittes (12).

2. Leiterplattenanordnung nach Anspruch 1, **dadurch gekennzeichnet, dass** die Kontaktflächen (6) der ersten Leiterplatte (2) oder die Kontaktflächen (10) der zweiten Leiterplatte (8) tropfenförmig ausgebildet sind.

3. Leiterplattenanordnung nach mindestens einem der vorhergehenden Ansprüche, **dadurch gekennzeichnet, dass** ein Kontaktmittenabstand (7) im Bereich von 0,5 mm bis 2 mm , insbesondere 0,5 mm bis 1,5 mm, insbesondere von 1,25 mm liegt.

4. Sensor, insbesondere Lichtschranke oder Lichttaster, mit einer Leiterplattenanordnung 1 nach mindestens einem der vorhergehenden Ansprüche 1 bis 3.

## Claims

1. A circuit board arrangement having at least two circuit boards (2, 8) standing perpendicular to one another, wherein a first circuit board (2) has first contact surfaces (6) at a side (4) at a circuit board edge (3);
wherein a second circuit board (8) has second contact surfaces (10) at a side (4), with the second contact surfaces (10) of the second circuit board (8) being arranged in a perpendicular horizontal manner at the first contact surface (6) of the first circuit board (2) and with the first contact surfaces (6) of the first circuit board (2) being electrically connected to the second contact surfaces (10) of the second circuit board (8) by means of solder (5);
wherein
the contact surfaces (6, 10) of one circuit board (2, 8) along a connection point (11) to the other circuit board (8, 2) are overhanging with respect to oppositely disposed contact surfaces (10, 6) of the oppositely disposed circuit board (8, 2) and at least the contact surfaces (6, 10) of the oppositely disposed circuit board (2, 8) taper or reduce in size in the direction of the connection point (11), **characterized in that** the contact surfaces (6, 10) of a circuit board (2, 8) have at least one circular surface section (12) and a connected rectangular surface section (13), with the rectangular surface section (13) being disposed between the circular surface section (12) and the connection point (11) and with the rectangular surface section (13) having a smaller width than a diameter of the circular surface section (12).

2. A circuit board arrangement in accordance with claim 1, **characterized in that** the contact surfaces (6) of the first circuit board (2) or the contact surfaces (10) of the second circuit board (8) are formed in droplet shape.

3. A circuit board arrangement in accordance with at least one of the preceding claims, **characterized in that** a contact center-to-center distance (7) is in the range from 0.5 mm to 2 mm, in particular 0.5 mm to 1.5 mm, in particular of 1.25 mm.

4. A sensor, in particular a light barrier or a light scanner, comprising a circuit board arrangement (1) in accordance with at least one of preceding claims 1 to 3.

## Revendications

1. Ensemble de cartes à circuits imprimés comportant au moins deux cartes à circuits imprimés (2, 8) disposés perpendiculairement l'une par rapport à l'autre, dans lequel une première carte à circuits imprimés (2) comprend sur un côté (4) de premières surfaces de contact (6) sur un bord (3) de la carte à circuits imprimés, une seconde carte à circuits imprimés (8) comprend sur un côté (4) de secondes surfaces de contact (10), les secondes surfaces de contact (10) de la seconde carte à circuits imprimés (8) sont disposées perpendiculairement contre les premières surfaces de contact (6) de la première carte à circuits imprimés (2), et les premières surfaces de contact (6) de la première carte à circuits imprimés (2) sont connectées électriquement aux secondes surfaces de contact (10) de la seconde carte à circuits imprimés (9) par un matériau d'apport de brasage (5),
dans lequel
le long d'un emplacement de connexion (11) vers l'autre carte à circuits imprimés (8, 2), les surfaces de contact (6, 10) d'une carte à circuits imprimés (2, 8) sont en saillie par rapport à des surfaces de contact (10, 6) opposées de la carte à circuits imprimés (8, 2) opposée, et au moins les surfaces de contact (6, 10) de la carte à circuits imprimés opposée (2, 8) se rétrécissent ou se réduisent en direction de l'emplacement de connexion (11), **caractérisé en ce que**
les surfaces de contact (6, 10) d'une carte à circuits imprimés (2, 8) présentent au moins une portion de surface circulaire (12) et une portion de surface rectangulaire (13) reliée, la portion de surface rectangulaire (13) se trouvant entre la portion de surface circulaire (12) et l'emplacement de connexion (11), et la portion de surface rectangulaire (13) présentant une largeur plus petite que le diamètre de la portion de surface circulaire (12).

2. Ensemble de cartes à circuits imprimés selon la revendication 1, **caractérisé en ce que** les surfaces de contact (6) de la première carte à circuits imprimés (2) ou les surfaces de contact (10) de la seconde carte à circuits imprimés (8) sont réalisées en forme de goutte.

3. Ensemble de cartes à circuits imprimés selon l'une des revendications précédentes, **caractérisé en ce qu'**un entraxe (7) des contacts est dans la plage de 0,5 mm à 2 mm, en particulier de 0,5 mm à 1,5 mm, en particulier il est de 1,25 mm.

4. Capteur, en particulier barrière lumineuse ou détecteur photoélectrique, comportant un ensemble de cartes à circuits imprimés 1 selon l'une au moins des revendications précédentes 1 à 3.
